# FASCICULE DE BREVET EUROPEEN

(11) **EP 2 786 317 B1**
(45) Date de publication et mention de la délivrance du brevet: **26.08.2015**
(21) Numéro de dépôt: 12816693.1
(22) Date de dépôt: 30.11.2012
(51) Int. Cl.: G06K 19/07, G06F 3/06, G11C 16/10

(54) **ECRITURE DE DONNÉES DANS UNE MÉMOIRE NON VOLATILE DE CARTE À PUCE**
SCHREIBEN VON DATEN IN EINEN NICHTFLÜCHTIGEN SPEICHER EINER CHIPKARTE
WRITING DATA IN A NON-VOLATILE MEMORY OF A SMART CARD

(30) Priorité: 02.12.2011 FR 1161102
(43) Date de publication de la demande: 08.10.2014
(73) Titulaire: Morpho, 92445 Issy-les-Moulineaux (FR)
(72) Inventeur: BARTHE, Michaël, 92445 Issy-Les-Moulineaux (FR); SPINAU, Geoffrey, 92445 Issy-Les-Moulineaux (FR)
(74) Mandataire: Cabinet Plasseraud
(86) Numéro de dépôt international: PCT/FR2012/052770
(87) Numéro de publication internationale: WO 2013/079885

(56) Documents cités:
- FR-A1- 2 842 622
- US-A1- 2006 079 254
- US-A1- 2009 187 709

## Description

L'invention concerne l'écriture de données dans une mémoire non volatile de carte à puce.

Les cartes à puce comprennent généralement à la fois de la mémoire non volatile et de la mémoire volatile.

Les mémoires dites "non volatiles" sont des mémoires qui peuvent conserver des données sans nécessiter d'alimentation externe. Les mémoires non volatiles peuvent être programmables (par exemple les mémoires de type EEPROM, Flash, etc.) ou non programmable (comme par exemple les mémoires de type ROM, dont le contenu est défini une fois pour toutes lors de la fabrication). Les mémoires non volatiles programmables servent souvent à stocker des données ou des applications susceptibles de fluctuer d'une carte à l'autre, par exemple un système de fichiers contenant différents répertoires et sous répertoires, des fichiers avec des données propres au porteur de carte (nom, coordonnées, etc.), des applets Javacard, etc. Les cartes à puce disposent généralement d'une capacité d'environ 8Ko à 256Ko de mémoire non volatile programmable (souvent de l'EEPROM). Les mémoires non volatiles non programmables servent souvent à stocker un système d'exploitation, et de façon générale des données qui ne sont pas susceptibles de changer d'une carte à l'autre. Les cartes à puce disposent généralement d'une capacité d'environ 64Ko à 512Ko de mémoire ROM. Bien entendu, d'autres capacités en RAM, EEPROM ou ROM existent également. Certaines cartes à puce utilisent, à la place du couple ROM, EEPROM, de la mémoire Flash.

Les mémoires dites "volatiles" (par exemple les mémoires de type RAM) sont des mémoires qui perdent leur contenu lorsque l'alimentation externe qui leur fournit de l'énergie est interrompue. Les mémoires volatiles sont typiquement beaucoup plus rapides que les mémoires non volatiles en particulier pour les opérations d'écriture. Par exemple une écriture EEPROM ou Flash est généralement beaucoup plus lente qu'une écriture RAM. Les mémoires volatiles permettent par exemple de manipuler des données temporaires (variables d'état, résultats de calculs, etc.) lors de l'exécution d'un logiciel. Les cartes à puces comprennent généralement une mémoire RAM, qui est souvent comprise entre 2Ko et 8Ko. Une grande partie de cette RAM est généralement occupée par des variables (notamment du système d'exploitation de la carte) et par différentes applications. Une partie de la mémoire RAM est généralement occupée par une mémoire tampon (buffer en anglais), qui est une zone dont la taille est typiquement de quelques centaines d'octets, dédiée à la réception de commandes.

Les cartes à puce ne permettent généralement pas à une entité extérieure d'écrire directement dans l'une quelconque de leur mémoire par adressage direct. Au contraire, les cartes à puce offrent généralement une interface (telle qu'une interface de type ISO 7816-4) grâce à laquelle une entité extérieure peut envoyer des commandes à la carte (notamment des commandes d'écriture ou de lecture). Les commandes sont reçues dans la mémoire tampon. Ainsi, la carte est elle-même en charge d'exécuter les commandes reçues, et peut ainsi choisir de les traiter ou de les refuser, d'interdire certains accès, de conditionner certains accès à une authentification, etc. Selon le protocole T=0 de la norme ISO 7816-4, qui est le protocole le plus courant, les commandes comprennent cinq octets (octet de classe, octet d'instruction et trois octets de paramètres P1, P2 et P3), suivis éventuellement de données (par exemple des données à écrire dans la carte). La longueur de ces données éventuelles est généralement spécifiée par l'octet P3, ainsi on n'envoie pas plus de 255 octets (plus les 5 octets précédents) d'un coup. Ceci requiert néanmoins une mémoire tampon d'au moins 260 octets. Il existe également des variantes et d'autres protocoles (par exemple le protocole T=1, qui est à même d'envoyer et recevoir en théorie jusqu'à 64Ko de données en une commande).

Compte tenu de la relative faible taille de la mémoire tampon, ainsi que de la limitation du protocole T=0, il n'est généralement pas possible d'envoyer de très longues commandes à la carte. Ainsi, lorsque l'on souhaite écrire plus de 255 octets dans un fichier de la carte (en protocole T=0), on découpe généralement les données en sous ensembles plus petits (par exemple des blocs de 255 octets), et l'on envoie autant de commandes d'écriture que de blocs.

On peut par exemple utiliser la commande UPDATE BINARY (instruction 0xD6 de la norme ISO 7816-4), qui permet d'écrire dans un fichier dit transparent. Il s'agit d'un fichier de type EF (Elementary File), dans lequel on peut écrire en spécifiant l'adresse cible (comprise entre 0x0000, pour le début du fichier, et l'adresse correspondant à la taille du fichier moins un octet, si l'on souhaite modifier le dernier octet du fichier). Cependant, ceci nécessite de calculer, dans l'entité émettrice, non seulement les sous ensembles de données (blocs de 255 octets), mais également de calculer l'adresse à laquelle il faut écrire chaque bloc dans le fichier cible, ce qui n'est pas pratique.

Il est également connu d'utiliser une commande UPDATE RECORD (instruction 0xDC de la norme ISO 7816-4), qui permet de créer un fichier EF à enregistrements, chaque enregistrement étant identifié par un index, chaque enregistrement pouvant éventuellement avoir une taille différente (selon les cartes). Cependant, ceci nécessite de calculer des index d'enregistrements, ce qui est peu pratique. De surcroît, il est parfois nécessaire d'écrire des blocs d'une certaine taille (par exemple des blocs de 11 octets) mais de lire des blocs d'une autre taille (par exemple des blocs de 13 octets), dans ce cas la structure d'un fichier à enregistrements est très peu pratique puisque les données à lire se situent à cheval sur plusieurs enregistrements et portions d'enregistrements).

Il est également connu d'utiliser une commande PUT DATA (instruction 0xDA de la norme ISO 7816-4). La norme précise que selon l'objet sélectionné (dans lequel la commande PUT DATA a vocation à écrire), il est possible d'effectuer soit une opération de type "writing once" soit de type "updating" soit de type "appending". Cependant, le mode opératoire de l'opération de type "appending" n'est pas spécifié dans la norme.

Le document US 2006/079254 divulgue une diffusion de mises à jour logicielles d'un ensemble de dispositifs tels que des téléphones portables munis de cartes SIM en effectuant une diffusion de messages au niveau des cellules d'un réseau cellulaire.

Le document FR 2 842 622 divulgue une copie de fichiers (par exemple fichier SMS) entre deux cartes à puce par exemple des SIM).

Le document US 2009/187709 concerne le streaming de données entre un hôte et un système de stockage (tel qu'une carte SD) comprenant une puce de carte à puce.

L'invention vise à améliorer la situation.

Un aspect de l'invention concerne un procédé d'écriture de données dans une mémoire non volatile de carte à puce, comprenant:
/a/ la réception, dans une mémoire tampon d'une mémoire volatile de la carte à puce, d'une commande d'écriture,
/b/ la comparaison par la carte à puce d'un paramètre d'identification d'objet associé à la commande d'écriture avec un paramètre d'identification d'objet stocké dans la mémoire non volatile de la carte à puce,
/c/ en cas de comparaison positive,
   /c1/ l'écriture des données à écrire, incluses dans la commande d'écriture, depuis la mémoire tampon vers l'objet associé à la commande d'écriture, à une adresse prédéfinie dont la valeur est stockée dans la mémoire non volatile,
   /c2/ le calcul d'une adresse correspondant à la somme de l'adresse prédéfinie stockée et de la taille des données écrites,
   /c3/ le stockage de l'adresse calculée dans la mémoire non volatile en lieu et place de l'adresse prédéfinie,
/d/ en cas de comparaison négative,
   /d1/ l'écriture des données à écrire incluses dans la commande d'écriture, depuis la mémoire tampon vers l'objet associé à la commande d'écriture, à une adresse par défaut,
   /d2/ le calcul d'une adresse correspondant à la somme de l'adresse par défaut et de la taille des données écrites,
   /d3/ le stockage de l'adresse calculée dans la mémoire non volatile en tant qu'adresse prédéfinie.

Ce procédé est avantageux en ce qu'il permet décrire de manière simple des données de taille importante dans la carte à puce. Il permet notamment d'écrire des données de longueur supérieure à la taille de la mémoire tampon de la carte, ainsi que des données de taille supérieure à la limite de 255 octets imposée par le protocole T=0, et ce sans nécessiter de calcul d'adresse ou d'index au niveau de l'entité envoyant les données. Ceci est particulièrement utile notamment dans le contexte de cartes mettant en oeuvre des techniques de biométrie, telles que des techniques dites de "match-on-card" permettant une authentification de données biométriques par la carte elle même. En effet, les données biométriques (par exemple des empreintes digitales ou des données de reconnaissance faciale) peuvent être de très grande taille, jusqu'à plusieurs kilooctets.

Un aspect de l'invention concerne un programme d'ordinateur comprenant une série d'instructions qui, lorsqu'elles sont exécutées par un processeur de carte à puce, mettent en oeuvre un procédé selon un aspect de l'invention.

Un aspect de l'invention concerne un support de stockage non transitoire lisible par ordinateur stockant un programme d'ordinateur selon un aspect de l'invention.

Un aspect de l'invention concerne une carte à puce comprenant une mémoire non volatile, une mémoire volatile, une mémoire tampon comprise dans la mémoire volatile, et un circuit de traitement de commandes d'écriture en mémoire non volatile, le circuit étant agencé pour traiter une commande stockée dans la mémoire tampon et associée à un paramètre d'identification d'un objet stocké dans la mémoire non volatile dans lequel la commande doit écrire, ledit circuit étant agencé pour stocker dans la mémoire non volatile, d'une part un paramètre d'identification d'un objet, l'objet étant stocké dans la mémoire non volatile, et d'autre part une adresse prédéfinie à l'intérieur de cet objet, le circuit étant agencé, lors du traitement d'une commande d'écriture, pour comparer le paramètre d'identification d'objet associé à la commande d'écriture avec le paramètre d'identification d'objet stocké dans la mémoire non volatile, et, en cas de comparaison positive, pour écrire les données à écrire, incluses dans la commande d'écriture, depuis la mémoire tampon vers l'objet associé à la commande d'écriture, à l'adresse prédéfinie stockée dans la mémoire non volatile, pour calculer une adresse correspondant à la somme de l'adresse prédéfinie stockée et de la taille des données écrites, ainsi que pour stocker l'adresse calculée dans la mémoire non volatile en lieu et place de l'adresse prédéfinie, le circuit étant agencé, en cas de comparaison négative, pour écrire les données à écrire incluses dans la commande d'écriture, depuis la mémoire tampon vers l'objet associé à la commande d'écriture, à une adresse par défaut, pour calculer une adresse correspondant à la somme de l'adresse par défaut et de la taille des données écrites, et pour stocker l'adresse calculée dans la mémoire non volatile en tant qu'adresse prédéfinie.

Un aspect de l'invention concerne un système comprenant un dispositif électronique et une carte à puce selon un aspect de l'invention, le dispositif électronique étant agencé pour séparer des données à écrire par le dispositif dans la carte à puce en sous ensembles tels que la taille de chaque sous ensemble soit au plus égale à une valeur déterminée, pour construire un ensemble de commandes d'écriture associées à un même objet de la carte, chaque commande d'écriture comprenant un sous ensemble respectif de données à écrire, et pour envoyer à la carte chaque commande d'écriture ainsi construite.

D'autres aspects, buts et avantages de l'invention apparaîtront de manière non limitative à la lecture de la description de quelques uns de ses modes de réalisation.

L'invention sera également mieux comprise à l'aide des dessins, sur lesquels :
- la Figure 1 illustre six exécutions consécutives d'un procédé selon un mode de réalisation de l'invention ;
- la Figure 2 illustre un système composé d'un ordinateur portable, d'un lecteur de cartes à puce connecté à cet ordinateur, et d'une carte à puce selon un mode de réalisation de l'invention ;
- la Figure 3 illustre de façon schématique l'architecture d'une carte à puce selon un mode de réalisation de l'invention.

Un mode de réalisation possible concerne un procédé d'écriture de données dans une mémoire non volatile (telle qu'une mémoire EEPROM ou Flash) de carte à puce. Le procédé comprend la réception d'une commande d'écriture. Cette commande peut par exemple être une commande formatée comme une commande de type PUT DATA de la norme ISO 7816-4, mais fonctionnellement modifiée de la manière précisée ci-dessous. Il est possible d'utiliser pour cette commande d'écriture un codé d'instruction différent du code d'instruction INS, de valeur 0xDA ou 0xDB, prévu par la norme ISO 7816-4 (tel qu'un code d'instruction non utilisé) de façon à pouvoir utiliser également la commande PUT DATA conventionnelle. Cette commande d'écriture reçue peut ainsi comprendre un en-tête contenant différent paramètres tels que le type de commande (notamment son code d'instruction INS, dans le cas d'une commande selon la norme ISO 7816-4), et les données à écrire. Cette commande est reçue, depuis une entité extérieure à la carte (telle qu'un terminal bancaire, un téléphone portable ou encore un lecteur de cartes à puce connecté à un ordinateur) dans une mémoire tampon d'une mémoire volatile (telle qu'une mémoire RAM) de la carte à puce. La réception peut s'effectuer notamment à travers l'interface d'entrées sorties de la carte à puce (en utilisant par exemple le contact IO prévu par la norme ISO 7816-3).

Le procédé comprend la comparaison, par la carte à puce, d'un paramètre d'identification d'objet associé à la commande d'écriture avec un paramètre d'identification d'objet stocké dans la mémoire non volatile de la carte à puce. La commande peut ainsi être associée à un certain objet de la carte, tel qu'un fichier de type EF. Cette association a notamment comme effet que la commande a pour vocation d'écrire les données qu'elle contient dans l'objet auquel elle est associée. Le paramètre d'identification d'objet stocké dans la mémoire non volatile peut identifier le dernier objet dans lequel la carte à puce a été amenée à écrire à l'aide d'une autre commande (d'écriture) selon un mode de réalisation de l'invention. Cette autre commande est une commande de même type, c'est-à-dire qu'elle a par exemple le même code d'instruction, à savoir le même octet INS au sens de la norme ISO 7816-4, et ne diffère par exemple que par ses paramètres (par exemple les paramètres P1, P2 et P3 au sens du protocole T=0) et par ses données (à savoir, dans le cas du protocole T=0, les octets suivant le cinquième octet de la commande). Lorsque la carte est initialisée (par exemple lors de sa première mise en route, ou lors de chaque mise sous tension), il est possible d'enregistrer, en tant que paramètre d'identification d'objet stocké dans la mémoire non volatile, une valeur par défaut, qui ne correspond à aucun objet possible (par exemple la valeur zéro, ou toute autre valeur choisie arbitrairement et conventionnellement à cette fin). Ainsi, la comparaison entre cette valeur par défaut et le paramètre d'identification d'objet associé à la commande d'écriture est nécessairement négative.

En cas de comparaison positive, c'est-à-dire si la commande d'écriture cherche à écrire dans le même objet que celui dans lequel la dernière commande d'écriture de même type à avoir été invoquée a écrit, le procédé peut mettre en oeuvre les étapes suivantes.

Une première étape comprend l'écriture des données à écrire (qui sont incluses dans la commande d'écriture), depuis la mémoire tampon (dans laquelle elles sont stockées après réception de la commande d'écriture, dont elles font partie) vers l'objet associé à la commande d'écriture, à une adresse prédéfinie dont la valeur est stockée dans la mémoire non volatile. La carte peut donc lire la valeur de l'adresse prédéfinie depuis la mémoire non volatile, puis écrire dans l'objet à cette adresse prédéfinie. Cette adresse prédéfinie est avantageusement une adresse relative au sein de l'objet. La carte peut ainsi écrire à une adresse absolue égale à la somme de l'adresse de l'objet (exprimée sous forme d'adresse absolue) et de l'adresse prédéfinie. Bien entendu, la carte peut mettre en oeuvre des mécanismes de sécurité visant à s'assurer que l'écriture s'effectue bien dans l'objet concerné (par exemple en vérifiant que l'adresse qui est égale à la somme de l'adresse prédéfinie et de la taille des données à écrire moins un se situe bien à l'intérieur de l'objet).

Une deuxième étape comprend le calcul d'une adresse correspondant à la somme de l'adresse prédéfinie stockée et de la taille des données écrites. Ceci correspond à l'adresse suivant immédiatement le dernier octet écrit.

Une troisième étape comprend le stockage de l'adresse calculée dans la mémoire non volatile en lieu et place de l'adresse prédéfinie. De cette façon, la prochaine invocation d'une commande d'écriture de même type, écrira, à condition que cette commande de même type soit associée au même objet, à la suite de ce qui vient d'être écrit, sans que l'entité (par exemple un téléphone portable) chargée de construire et d'envoyer cette commande d'écriture n'ait eu besoin de mémoriser l'adresse précédente ni de calculer la nouvelle adresse.

En cas de comparaison négative, c'est-à-dire si la commande d'écriture cherche à écrire dans un objet différent de celui dans lequel la dernière commande d'écriture de même type à avoir été invoquée a écrit, ou si c'est la première fois qu'une commande d'écriture de ce type est invoquée, le procédé peut mettre en oeuvre les étapes suivantes.

Une première étape comprend l'écriture des données à écrire incluses dans la commande d'écriture, depuis la mémoire tampon vers l'objet associé à la commande d'écriture, à une adresse par défaut. Cette adresse par défaut est avantageusement une adresse relative au sein de l'objet. La carte peut ainsi écrire à une adresse absolue égale à la somme de l'adresse de l'objet (exprimée sous forme d'adresse absolue) et de l'adresse par défaut. Bien entendu, la carte peut mettre en oeuvre des mécanismes de sécurité visant à s'assurer que l'écriture s'effectue bien dans l'objet concerné (par exemple en vérifiant que l'adresse qui est égale à la somme de l'adresse par défaut et de la taille des données à écrire moins un se situe bien à l'intérieur de l'objet).

Une deuxième étape comprend le calcul d'une adresse correspondant à la somme de l'adresse par défaut et de la taille des données écrites. Ceci correspond à l'adresse suivant immédiatement le dernier octet écrit.

Une troisième étape comprend le stockage de l'adresse calculée dans la mémoire non volatile en tant qu'adresse prédéfinie. De cette façon, la prochaine invocation d'une commande d'écriture de même type, écrira, à condition que cette commande de même type soit associée au même objet, à la suite de ce qui vient d'être écrit, sans que l'entité (par exemple un téléphone portable) chargée de construire et d'envoyer cette commande d'écriture n'ait eu besoin de mémoriser l'adresse précédente ni de calculer la nouvelle adresse.

Un mode de réalisation possible concerne un procédé dans lequel le paramètre d'identification d'objet associé à la commande d'écriture est inclus dans la commande d'écriture. Ainsi, on peut par exemple utiliser les paramètres P1 et P2 pour stocker un identifiant (File ID, en abrégé FID, au sens de la norme ISO 7816-4) d'un objet (par exemple d'un Elementary File EF au sens de la norme ISO 7816-4). Par exemple, dans l'hypothèse où la commande s'inspire de la commande UPDATE BINARY au sens de la norme ISO 7816-4, les paramètres P1 et P2 qui sont censés représenter une adresse interne de l'objet où il faut écrire ne sont plus nécessaires, et peuvent être remplacés par le File ID identifiant l'objet où il faut écrire.

Un mode de réalisation possible concerne un procédé dans lequel le paramètre d'identification d'objet associé à la commande d'écriture est stocké dans la mémoire volatile, et est mis à jour par une commande de sélection d'objet de la carte à puce. Par exemple, il est possible d'utiliser la commande SELECT FILE au sens de la norme ISO 7816-4 (qui a pour code d'instruction INS la valeur 0xA4), afin de sélectionner un EF dans lequel une commande d'écriture ultérieure viendra automatiquement écrire sans qu'il soit nécessaire que cette commande d'écriture indique explicitement dans quel objet elle doit écrire.

Un mode de réalisation possible concerne un procédé dans lequel l'adresse par défaut est l'adresse zéro. Ainsi, à chaque fois qu'une commande d'écriture selon un mode de réalisation de l'invention écrit dans un objet alors que la dernière commande d'écriture de même type qui a été invoquée (s'il y en a eu une) avait écrit dans un autre objet, et à chaque fois que c'est la première fois qu'une commande d'écriture de ce type est invoquée (par exemple la première fois au sein d'une session particulière, ou la première fois après mise sous tension de la carte, ou la première fois dans l'absolu depuis la fabrication de la carte), le procédé écrit à l'adresse zéro. Il s'agit évidemment d'une adresse zéro qui est relative à l'objet considéré, et qui correspond au début de cet objet.

Alternativement, il est possible d'utiliser une adresse par défaut différente de zéro. Par exemple, si la structure des objets dans lesquels la commande d'écriture selon un mode de réalisation de l'invention a vocation à écrire est telle que l'on ne peut écrire qu'à certaines adresses, et pas au tout début de l'objet (qui contient par exemple des données administratives gérées par la carte elle-même), il est possible d'utiliser comme valeur par défaut une adresse valide dans cet objet.

Cette valeur par défaut, lorsqu'elle est commune à tous les objets, et lorsque le procédé est mis en oeuvre par un logiciel, peut être stockée dans le code proprement dit (le code pouvant être stocké en mémoire ROM par exemple).

L'adresse par défaut peut varier de type d'objet en type objet (la carte stockant par exemple différentes valeurs d'adresses par défaut, pour chaque type d'objet). Dans ce cas, les différentes valeurs par défaut peuvent être par exemple stockées dans un tableau en mémoire ROM. Elles peuvent être stockées dans un tableau en mémoire EEPROM ou Flash si elles sont susceptibles de changer, ou si le concepteur de la carte n'est pas en mesure d'anticiper les types d'objet utilisables. Des types d'objet peuvent en effet être, par exemple : fichier EF transparent stockant des empreintes digitales, fichier EF transparent stockant des données de reconnaissance faciale, fichier EF transparent stockant des dates, fichier EF transparent stockant des lieux, fichier EF transparent stockant des adresses géographiques (par exemple : numéro de rue, nom de rue, ville, pays), etc. On constate ainsi qu'un type d'objet ne correspond pas nécessairement (bien que cela puisse être le cas) à un type de fichier (tel que le type ISO 7816-4 "transparent EF"), mais peut correspondre à une subdivision plus fine correspondant au contenu de ces fichiers, qui ne relève pas d'une définition par le système d'exploitation de la carte à puce, mais par une entité utilisant la carte à puce. Dans ce cas un tableau en mémoire EEPROM ou Flash est généralement plus approprié.

Il est également envisageable qu'une valeur par défaut soit associée à chaque objet particulier (c'est-à-dire à chaque instance d'objet, deux objets différents mais de même type pouvant alors être associés à deux valeurs par défaut différentes). Deux fichiers EF transparents contenant des empreintes digitales peuvent ainsi être associés à des valeurs par défaut différentes. Cette valeur par défaut peut être la valeur zéro (ou une valeur autre, fonction du type de l'objet, comme indiqué au paragraphe précédent), lorsque l'objet est créé, puis elle peut être mise à jour. Elle peut être stockée dans l'objet lui-même, ou avec l'objet, dans la mémoire non volatile réinscriptible (EEPROM ou Flash par exemple). Selon un mode de réalisation possible, la carte à puce ne stocke qu'une seule valeur prédéfinie, quel que soit le nombre d'objets. Cette valeur prédéfinie est alors réinitialisée à chaque fois qu'une commande d'écriture selon un mode de réalisation de l'invention écrit dans un nouvel objet (à savoir un objet distinct de l'objet dans lequel la dernière commande du même type qui a été invoquée à écrit, ou un premier objet). Dans ce cas, la mise à jour de la valeur par défaut stockée pour un objet donné peut consister à recopier la valeur prédéfinie associée à cet objet afin de l'utiliser comme valeur par défaut. Ainsi, si une entité extérieure écrit, avec des commandes d'écriture de même type, dans un premier objet, puis dans un second, puis à nouveau dans le premier, elle écrira à nouveau dans le premier objet à la suite de ce qu'elle avait écrit initialement, sans écraser les valeurs initialement écrites. Dans le cas où une mise à jour automatique de la valeur par défaut est mise en oeuvre par la carte à puce, il est avantageux de fournir, au sein de la carte, une commande de réinitialisation de la valeur par défaut, pouvant par exemple lui attribuer la valeur qui est attribuée lors de la création de l'objet. Ainsi, il est possible, avec une commande d'écriture selon un mode de réalisation de l'invention, de remplacer des données précédemment écrites dans l'objet considéré à l'aide d'une commande d'écriture selon un mode de réalisation de l'invention.

Un mode de réalisation possible concerne un procédé dans lequel la commande est codée sous forme de commande APDU selon la norme ISO 7816-4. La commande d'écriture peut être une commande APDU, et la commande de sélection éventuelle peut également être une commande APDU (il peut s'agir de la commande SELECT selon la norme ISO 7816-4). L'éventuelle commande de réinitialisation de la valeur par défaut peut également être une commande APDU.

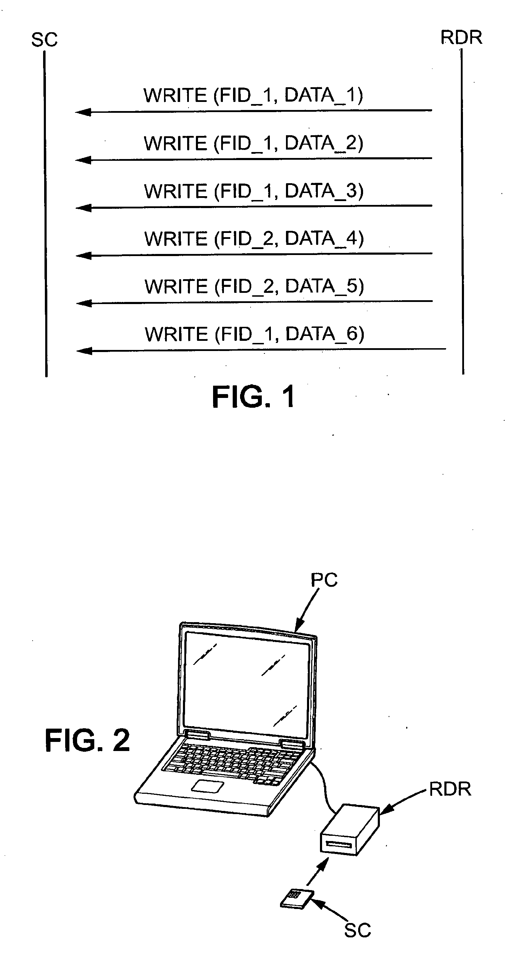

La figure 1 illustre l'utilisation répétée d'un procédé selon un mode de réalisation de l'invention. Un lecteur RDR envoie une première commande d'écriture WRITE(FID_1, DATA_1) à une carte à puce SC selon un mode de réalisation de l'invention. La carte à puce reçoit pour la première fois l'instruction WRITE d'écrire dans le fichier ayant pour identifiant FID_1. Elle écrit donc les données DATA_1 au début du fichier. Le lecteur envoie une deuxième commande d'écriture WRITE(FID_1, DATA_2) à la carte à puce. La carte écrit alors les données DATA_2 à la suite des données DATA_1. Le lecteur envoie une troisième commande d'écriture WRITE(FID_1, DATA_3) à la carte à puce. La carte écrit alors les données DATA_3 à la suite des données DATA_2. Le lecteur envoie une quatrième commande d'écriture WRITE(FID_2, DATA_4) à la carte à puce. La carte détecte qu'elle reçoit une commande d'écriture dans un fichier distinct de celui dans lequel elle vient d'écrire. Elle écrit donc les données DATA_4 au début du fichier ayant pour identifiant FID_2. Le lecteur envoie une cinquième commande d'écriture WRITE(FID_2, DATA_5) à la carte à puce. La carte écrit alors les données DATA_5 à la suite des données DATA_4 dans le fichier ayant pour identifiant FID_2. Le lecteur envoie une sixième commande d'écriture WRITE(FID_1, DATA_6) à la carte à puce. La carte détecte qu'elle reçoit une commande d'écriture dans un fichier distinct de celui dans lequel elle vient d'écrire. Elle consulte la valeur d'adresse par défaut pour le fichier ayant pour identifiant FID_1 qui a été mise à jour lors des écritures précédentes dans ce fichier et écrit donc les données DATA_6 à la suite des données DATA_3.

Ce mode de fonctionnement est particulièrement avantageux notamment lorsque plusieurs applications du dispositif fonctionnent en mode multitâches et sont susceptibles d'envoyer des commandes d'écriture à la carte. La carte peut alors alterner les écritures dans différents fichiers, et les applications du dispositif n'ont pas besoin de se soucier des détails de l'organisation des fichiers, ni de calculer les adresses auxquelles il convient d'écrire. Dans un cas extrême, diverses applications qui ne communiquent pas nécessairement entre elles peuvent être amenées à écrire dans le même fichier de la carte à puce, par exemple dans un fichier de journal mémorisant des événements au fur et à mesure qu'ils se produisent. Aucune des deux applications ne peut alors isolément déterminer l'adresse à laquelle il conviendrait d'écrire le nouvel événement.

Selon un autre mode de réalisation (non représenté), une carte à puce comprend deux objets vides (01 et 02). Le procédé comprend la réception consécutive des commandes d'écriture de données (par exemple des données biométriques D1 à D7) suivantes :
Write(01, D1),
Write(O1, D2),
Write(01, D3),
Write(02, D4),
Write(02, D5),
Write(01, D6) puis
Write(01, D7).

Les données D1, D2 et D3 sont alors concaténées dans l'objet 01, l'objet 02 étant encore vide, puis les donnés D4 et D5 sont concaténées dans l'objet 02 (les données D1, D2 et D3 étant toujours dans l'objet 01) et enfin les données D1, D2 et D3 de l'objet 01 sont perdues (écrasées), les données D6 et D7 étant concaténées dans l'objet 01 en lieu et place des données D1 à D3. Dès que l'objet change (par exemple dès que le FID change), on peut ainsi écrire au début de l'objet nouvellement sélectionné en écrasant les anciennes données. Si la concaténation des données D1 à D3 était plus longue que la concaténation des données D6 et D7, le reliquat peut rester physiquement dans la mémoire de la carte à puce (à la suite des données D7) sans pour autant être considéré comme étant dans l'objet 01 (d'un point de vue logique). Par exemple, l'objet 01 peut comprendre un paramètre indiquant sa taille courante (correspondant en l'espèce à la taille de la concaténation des données D6 et D7), et toute information stockée au-delà de cette taille peut être ignorée. Ne pas effacer le reliquat limite le nombre d'opérations d'écriture en mémoire non volatile (un effacement étant une forme d'écriture), ce qui peut être avantageux, notamment pour accélérer le traitement (moins d'opérations d'écriture), ou encore pour améliorer la durée de vie de la mémoire non volatile (chaque opération d'écriture dégrade la mémoire, qui n'est garantie que pour un certain nombre de cycles d'écriture).

Un mode de réalisation possible concerne un procédé d'écriture de données dans une mémoire non volatile de carte à puce, par un dispositif électronique (tel qu'un téléphone portable, un terminal bancaire, etc.).

Le procédé comprend une séparation, par le dispositif, des données à écrire en sous ensembles. Les sous ensembles sont tels que la taille de chaque sous ensemble soit au plus égale à une valeur déterminée. Cette valeur déterminée peut être par exemple la quantité maximale de données à écrire que l'on peut transmettre dans une commande d'écriture selon un mode de réalisation, la commande d'écriture étant de taille égale à la valeur la plus faible entre la taille de la mémoire tampon de la mémoire volatile de la carte à puce (recevant les commandes), et la taille maximale d'une commande (par exemple, en T=0, une commande d'écriture fait au maximum 260 octets, et peut au maximum envoyer 255 octets).

Par exemple, un terminal de contrôle de passeport électronique (qui est une forme particulière de carte à puce) peut capter l'empreinte digitale d'un prétendu titulaire du passeport (par exemple lors d'un contrôle aux frontières, dans un aéroport), et la découper en tronçons contigus de 255 octets. Au moins l'un des tronçons, par exemple le dernier tronçon, peut avoir une taille inférieure si la taille de l'empreinte, en octets, n'est pas un multiple de 255. Chaque tronçon correspond alors à un sous ensemble ci-dessus.

Le procédé comprend une construction d'un ensemble de commandes d'écriture associées à un même objet de la carte, chaque commande d'écriture comprenant un sous ensemble respectif de données à écrire.

La construction de la commande peut par exemple consister à faire précéder chaque sous ensemble de données, par exemple chaque bloc de 255 octets représentant une partie d'empreinte digitale, par l'en-tête de la commande d'écriture.

L'en-tête peut prendre la forme {CLA, INS, P1, P2, P3}, les valeurs CLA, INS, P1, P2 et P3 étant chacune codée sur un octet, la commande résultante ayant ainsi une taille de 260 octets. P3 peut être égale à 0xFF afin d'indiquer que 255 octets de données à écrire suivent les cinq octets d'en-tête. P1 et P2 peuvent être égaux à zéro. Alternativement, P1∥P2 peut représenter l'identifiant d'un fichier dans lequel la commande d'écriture a vocation à écrire les données. L'octet INS peut prendre par exemple toute valeur non spécifiée par le standard ISO 7816-4, ou toute valeur spécifiée mais non utilisée par la carte à puce considérée. En effet, la norme ISO 7816-4 n'impose pas d'implémenter la totalité des instructions qu'elle spécifie. Cette dernière option (réutilisation d'un code d'instruction standardisé mais non utilisé auparavant dans la carte) conduit à une carte ne respectant pas strictement le standard ISO 7816-4. Ce non respect n'est pas nécessairement gênant (cela dépend des applications). L'octet de classe (CLA) peut prendre toute valeur appropriée.

Le procédé comprend l'envoi, par le dispositif, à la carte à puce, de chaque commande d'écriture. Le dispositif envoie les commandes comprenant les sous ensembles dans l'ordre que ces sous ensembles occupaient dans les données à écrire (avant leur séparation). Ainsi, les données écrites dans la mémoire non volatile de la carte à puce sont identique à celles qui étaient censées être écrites.

Le procédé comprend enfin le traitement, par la carte à puce, de chaque commande reçue, selon un procédé selon un mode de réalisation de l'invention.

Selon une autre mode de réalisation, le dispositif reçoit ou acquiert les données à écrire dans la carte à puce au fur et à mesure, et les fait suivre progressivement à la carte (en construisant des commandes d'écriture au fur et à mesure). Dans ce cas, à moins qu'il reçoive d'un coup plus de 255 octets (dans le cas du protocole T=0), ou plus de la taille de la mémoire tampon de la carte (si cette dernière est inférieure à 260 octets), le dispositif n'a pas besoin de créer lui-même les sous ensembles.

Dans le cas où la mémoire tampon de la carte à puce a taille inférieure à 260 octets, il est avantageux de prévoir un envoi de la taille de cette mémoire tampon au dispositif utilisateur. Cette taille peut figurer par exemple dans les octets libres de l'ATR (Answer To Reset) spécifié dans la norme ISO 7816. Dans le cas général, le facteur limitatif est plutôt la taille de 255 octets imposée par T=0 plutôt que la taille du tampon (qui est en général au moins égale à 255 octets), il n'est alors pas nécessaire de transmettre la taille de la mémoire tampon.

Un mode de réalisation possible concerne un programme d'ordinateur comprenant une série d'instructions qui, lorsqu'elles sont exécutées par un processeur de carte à puce, mettent en oeuvre le procédé selon un mode de réalisation de l'invention. Ces instructions peuvent être par exemple des instructions en langage assembleur, ou, pour les cartes à puce dont le processeur est programmable en langage de plus haut niveau (par exemple langage C ou Java), en ce langage plus évolué.

Un mode de réalisation possible concerne un support de stockage non transitoire lisible par ordinateur stockant un programme d'ordinateur selon un mode de réalisation de l'invention. Le support de stockage peut être par exemple la mémoire ROM, Flash ou EEPROM d'une carte à puce.

Un mode de réalisation possible concerne une carte à puce SC comprenant une mémoire non volatile EEPROM, une mémoire volatile RAM, une mémoire tampon BUF comprise dans la mémoire volatile, et un circuit PROC, ROM de traitement de commandes d'écriture en mémoire non volatile.

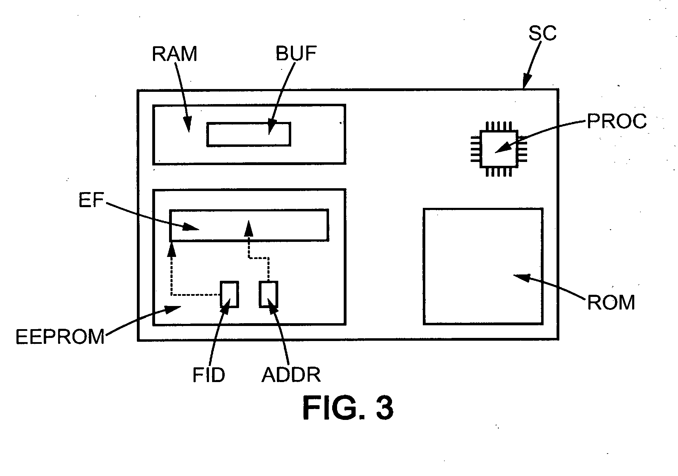

Le circuit peut comprendre un processeur de carte à puce ainsi qu'une mémoire (par exemple une mémoire ROM) comprenant un logiciel exécutable par le processeur et mettant en oeuvre un procédé selon un mode de réalisation de l'invention. Le processeur PROC représenté sur la figure 3 se présente sous forme de circuit intégré en boîtier DIP. Cependant il s'agit d'une représentation schématique, un processeur de carte à puce étant généralement intégré au sein d'un microcontrôleur comprenant également les différentes mémoires (RAM, EEPROM, ROM...). Ce microcontrôleur se présente typiquement sous forme de die (ou carré de semi-conducteur) découpé à partir d'un wafer et fixé sur un module de façon conventionnelle. Le circuit peut également être réalisé de façon complètement électronique, sans processeur ni logiciel (par exemple à l'aide de logique câblée, ou à l'aide d'un FPGA).

Le circuit est agencé pour traiter une commande stockée dans la mémoire tampon. La commande est associée à un paramètre d'identification. Ce paramètre d'identification peut être stocké en mémoire volatile. Ce paramètre d'identification identifie un objet stocké dans la mémoire non volatile. La commande doit écrire dans cet objet. Le circuit est également agencé pour stocker, dans la mémoire non volatile, un paramètre d'identification FID d'un objet EF. L'objet EF est stocké dans la mémoire non volatile (il peut s'agir de l'objet précité, qui est associé à la commande, ou d'un autre objet). Le circuit est agencé pour stocker, dans la mémoire non volatile, une adresse prédéfinie ADDR. Cette adresse prédéfinie est une adresse située à l'intérieur de cet objet EF. Le circuit est agencé, lors du traitement d'une commande d'écriture, pour comparer le paramètre d'identification d'objet associé à la commande d'écriture avec le paramètre d'identification FID d'objet EF stocké dans la mémoire non volatile.

Le circuit est agencé, en cas de comparaison positive, pour écrire les données à écrire, incluses dans la commande d'écriture, depuis la mémoire tampon, vers l'objet associé à la commande d'écriture, à l'adresse prédéfinie stockée dans la mémoire non volatile. Le circuit est agencé pour calculer une adresse correspondant à la somme de l'adresse prédéfinie stockée ADDR et de la taille des données écrites. Le circuit est agencé pour stocker l'adresse calculée dans la mémoire non volatile en lieu et place de l'adresse prédéfinie ADDR.

Le circuit est agencé, en cas de comparaison négative, pour écrire les données à écrire incluses dans la commande d'écriture, depuis la mémoire tampon vers l'objet associé à la commande d'écriture, à une adresse par défaut. Le circuit est agencé pour calculer une adresse correspondant à la somme de l'adresse par défaut et de la taille des données écrites. Le circuit est agencé pour stocker l'adresse calculée dans la mémoire non volatile en tant qu'adresse prédéfinie.

Un mode de réalisation possible concerne un système comprenant un dispositif électronique (tel qu'un couple ordinateur PC et lecteur de carte RDR) et une carte à puce SC selon un mode de réalisation possible de l'invention. Le dispositif électronique est agencé pour séparer des données à écrire par le dispositif dans la carte à puce en sous ensembles tels que la taille de chaque sous ensemble soit au plus égale à une valeur déterminée. Le dispositif électronique est agencé pour construire un ensemble de commandes d'écriture associées à un même objet de la carte, chaque commande d'écriture comprenant un sous ensemble respectif de données à écrire. Le dispositif électronique est agencé pour envoyer à la carte chaque commande d'écriture ainsi construite.

Les modes de réalisations décrits en relation avec le procédé selon l'invention peuvent être transposés à la carte à puce et au système selon l'invention, ainsi qu'aux programmes d'ordinateur et aux supports de stockage du programme selon l'invention, et réciproquement.

L'invention a été illustrée ci-dessus à l'aide d'exemple particulier, mais ne se limite pas à ces exemples. En particulier, l'invention s'applique aux cartes à puce sous toutes leurs formes (cartes sans contact ou à contact, clés USB sécurisées, cartes d'identités électroniques, cartes SIM, cartes bancaires, cartes d'accès, tokens sécurisés, passeports électroniques, chronotachygraphes, cartes des santé, visas électroniques, cartes SecureMMC, etc.). Les dispositifs électroniques envoyant des commandes d'écriture à la carte à puce peuvent être toutes sortes de dispositifs (distributeur automatique de billets de banques, machine de péage autoroutier, terminal de paiement de type POS, borne de lecture de carte santé, station de personnalisation de carte à puce, machine de production de carte à puce, téléphone portable, ordinateur équipé d'un lecteur de cartes à puce, station de vérification de passeport électronique, etc.).

Une commande d'écriture selon un mode de réalisation de l'invention peut être chaînée, c'est-à-dire qu'il est possible, notamment quand la mémoire tampon est supérieure à la taille maximale d'une telle commande, d'envoyer plusieurs commandes d'affilée et de n'effectuer l'écriture en mémoire non volatile que lors de la dernière des commandes. Par exemple, si la mémoire tampon permet de contenir trois commandes, et que les données à écrire requièrent douze commandes, la carte à puce peut chaîner des séries de trois commandes et n'effectuer ainsi que quatre étapes d'écriture et non douze (mais sur des données trois fois plus longues).

Bien que les exemples donnés aient été essentiellement des exemples s'appuyant sur le protocole T=0, l'invention fonctionne avec d'autres protocoles. Par exemple, une commande d'écriture selon un mode de réalisation de l'invention peut être une commande selon le protocole T=1, la carte devant simplement s'assurer que la commande n'est pas plus longue que la taille de sa mémoire tampon.

## Revendications

1. Procédé d'écriture de données dans une mémoire non volatile de carte à puce, comprenant :
/a/ la réception, dans une mémoire tampon d'une mémoire volatile de la carte à puce, d'une commande d'écriture,
/b/ la comparaison par la carte à puce d'un paramètre d'identification d'objet associé à la commande d'écriture avec un paramètre d'identification d'objet stocké dans la mémoire non volatile de la carte à puce,
/c/ en cas de comparaison positive,
/c1/ l'écriture des données à écrire, incluses dans la commande d'écriture, depuis la mémoire tampon vers l'objet associé à la commande d'écriture, à une adresse prédéfinie dont la valeur est stockée dans la mémoire non volatile,
/c2/ le calcul d'une adresse correspondant à la somme de l'adresse prédéfinie stockée et de la taille des données écrites,
/c3/ le stockage de l'adresse calculée dans la mémoire non volatile en lieu et place de l'adresse prédéfinie,
/d/ en cas de comparaison négative,
/d1/ l'écriture des données à écrire incluses dans la commande d'écriture, depuis la mémoire tampon vers l'objet associé à la commande d'écriture, à une adresse par défaut,
/d2/ le calcul d'une adresse correspondant à la somme de l'adresse par défaut et de la taille des données écrites,
/d3/ le stockage de l'adresse calculée dans la mémoire non volatile en tant qu'adresse prédéfinie.

2. Procédé selon la revendication 1, dans lequel le paramètre d'identification d'objet associé à la commande d'écriture est inclus dans la commande d'écriture.

3. Procédé selon la revendication 1, dans lequel le paramètre d'identification d'objet associé à la commande d'écriture est stocké dans la mémoire volatile, et est mis à jour par une commande de sélection d'objet de la carte à puce.

4. Procédé selon l'une des revendications précédentes, dans lequel l'adresse par défaut est l'adresse zéro.

5. Procédé selon l'une des revendications précédentes, dans lequel la commande est codée sous forme de commande APDU selon la norme ISO 7816-4.

6. Procédé d'écriture de données dans une mémoire non volatile de carte à puce, par un dispositif électronique, le procédé comprenant :
/a/ une séparation, par le dispositif, des données à écrire en sous ensembles tels que la taille de chaque sous ensemble soit au plus égale à une valeur déterminée,
/b/ une construction d'un ensemble de commandes d'écriture associées à un même objet de la carte, chaque commande d'écriture comprenant un sous ensemble respectif de données à écrire,
/c/ l'envoi par le dispositif à la carte de chaque commande d'écriture,
/d/ le traitement par la carte de chaque commande reçue, selon le procédé selon l'une des revendications 1 à 5.

7. Programme d'ordinateur comprenant une série d'instructions qui, lorsqu'elles sont exécutées par un processeur de carte à puce, mettent en oeuvre le procédé selon l'une des revendications 1 à 5.

8. Support de stockage non transitoire lisible par ordinateur stockant un programme d'ordinateur selon la revendication 7.

9. Carte à puce (SC) comprenant une mémoire non volatile (EEPROM), une mémoire volatile (RAM), une mémoire tampon (BUF) comprise dans la mémoire volatile, et un circuit (PROC, ROM) de traitement de commandes d'écriture en mémoire non volatile, le circuit (PROC, ROM) étant agencé pour traiter une commande stockée dans la mémoire tampon (BUF) et associée à un paramètre d'identification d'un objet stocké dans la mémoire non volatile (EEPROM) dans lequel la commande doit écrire, ledit circuit (PROC, ROM) étant agencé pour stocker dans la mémoire non volatile (EEPROM), d'une part un paramètre d'identification (FID) d'un objet (EF), l'objet (EF) étant stocké dans la mémoire non volatile (EEPROM), et d'autre part une adresse prédéfinie (ADDR) à l'intérieur de cet objet (EF), le circuit (PROC, ROM) étant agencé, lors du traitement d'une commande d'écriture, pour comparer le paramètre d'identification d'objet associé à la commande d'écriture avec le paramètre d'identification (FID) d'objet (EF) stocké dans la mémoire non volatile (EEPROM), et, en cas de comparaison positive, pour écrire les données à écrire, incluses dans la commande d'écriture, depuis la mémoire tampon (BUF) vers l'objet associé à la commande d'écriture, à l'adresse prédéfinie (ADDR) stockée dans la mémoire non volatile (EEPROM), pour calculer une adresse correspondant à la somme de l'adresse prédéfinie stockée (ADDR) et de la taille des données écrites, ainsi que pour stocker l'adresse calculée dans la mémoire non volatile (EEPROM) en lieu et place de l'adresse prédéfinie (ADDR), le circuit (PROC, ROM) étant agencé, en cas de comparaison négative, pour écrire les données à écrire incluses dans la commande d'écriture, depuis la mémoire tampon (BUF) vers l'objet associé à la commande d'écriture, à une adresse par défaut, pour calculer une adresse correspondant à la somme de l'adresse par défaut et de la taille des données écrites, et pour stocker l'adresse calculée dans la mémoire non volatile (EEPROM) en tant qu'adresse prédéfinie.

10. Système comprenant un dispositif électronique (PC, RDR) et une carte à puce (SC) selon la revendication 9, le dispositif électronique (PC, RDR) étant agencé pour séparer des données à écrire par le dispositif (PC, RDR) dans la carte à puce (SC) en sous ensembles tels que la taille de chaque sous ensemble soit au plus égale à une valeur déterminée, pour construire un ensemble de commandes d'écriture associées à un même objet de la carte (SC), chaque commande d'écriture comprenant un sous ensemble respectif de données à écrire, et pour envoyer à la carte (SC) chaque commande d'écriture ainsi construite.

## Patentansprüche

1. Verfahren zum Schreiben von Daten in einen nichtflüchtigen Chipkartenspeicher, das enthält:
/a/den Empfang eines Schreibbefehls in einem Pufferspeicher eines flüchtigen Speichers der Chipkarte,
/b/den Vergleich, durch die Chipkarte, eines dem Schreibbefehl zugeordneten Objekt-Identifikationsparameters mit einem im nichtflüchtigen Speicher der Chipkarte gespeicherten Objekt-Identifikationsparameter,
/c/im Fall eines positiven Vergleichs,
/c1/ das Schreiben der im Schreibbefehl enthaltenen zu schreibenden Daten aus dem Pufferspeicher in das dem Schreibbefehl zugeordnete Objekt an einer vordefinierten Adresse, deren Wert im nichtflüchtigen Speicher gespeichert ist,
/c2/ die Berechnung einer Adresse, die der Summe der gespeicherten vordefinierten Adresse und der Größe der geschriebenen Daten entspricht,
/c3/ das Speichern der berechneten Adresse im nichtflüchtigen Speicher anstelle der vordefinierten Adresse,
/d/im Fall eines negativen Vergleichs,
/d1/ das Schreiben der im Schreibbefehl enthaltenen zu schreibenden Daten aus dem Pufferspeicher in das dem Schreibbefehl zugeordnete Objekt an einer Standard-Adresse,
/d2/ die Berechnung einer der Summe der Standard-Adresse und der Größe der geschriebenen Daten entsprechenden Adresse,
/d3/ die Speicherung der berechneten Adresse im nichtflüchtigen Speicher als vordefinierte Adresse.

2. Verfahren nach Anspruch 1, wobei der dem Schreibbefehl zugeordnete Objekt-Identifikationsparameter im Schreibbefehl enthalten ist.

3. Verfahren nach Anspruch 1, wobei der dem Schreibbefehl zugeordnete Objekt-Identifikationsparameter im flüchtigen Speicher gespeichert und von einem Objektauswahlbefehl der Chipkarte aktualisiert wird.

4. Verfahren nach einem der vorhergehenden Ansprüche, wobei die Standard-Adresse die Nulladresse ist.

5. Verfahren nach einem der vorhergehenden Ansprüche, wobei der Befehl in Form eines APDU-Befehls gemäß der Norm ISO 7816-4 codiert ist.

6. Verfahren zum Schreiben von Daten in einen nichtflüchtigen Chipkartenspeicher durch eine elektronische Vorrichtung, wobei das Verfahren enthält:
/a/eine Aufteilung, durch die Vorrichtung, der zu schreibenden Daten in derartige Untermengen, dass die Größe jeder Untermenge höchstens gleich einem bestimmten Wert ist,
/b/einen Aufbau einer einem gleichen Objekt der Karte zugeordneten Gruppe von Schreibbefehlen, wobei jeder Schreibbefehl eine Untermenge von zu schreibenden Daten enthält,
/c/das Senden jedes Schreibbefehls durch die Vorrichtung an die Karte,
/d/die Verarbeitung jedes empfangenen Befehls durch die Karte gemäß dem Verfahren nach einem der Ansprüche 1 bis 5.

7. Computerprogramm, das eine Reihe von Anweisungen enthält, die, wenn sie von einem Chipkartenprozessor ausgeführt werden, das Verfahren nach einem der Ansprüche 1 bis 5 anwenden.

8. Computerlesbares, nicht-transientes Speichermedium, das ein Computerprogramm nach Anspruch 7 speichert.

9. Chipkarte (SC), die einen nichtflüchtigen Speicher (EEPROM), einen flüchtigen Speicher (RAM), einen im flüchtigen Speicher enthaltenen Pufferspeicher (BUF) und eine Verarbeitungsschaltung (PROC, ROM) von Schreibbefehlen im nichtflüchtigen Speicher enthält, wobei die Schaltung (PROC, ROM) eingerichtet ist, um einen im Pufferspeicher (BUF) gespeicherten und einem Identifikationsparameter eines im nichtflüchtigen Speicher (EEPROM), in den der Befehl schreiben soll, gespeicherten Objekts zugeordneten Befehl zu verarbeiten, wobei die Schaltung (PROC, ROM) eingerichtet ist, um im nichtflüchtigen Speicher (EEPROM) einerseits einen Identifikationsparameter (FID) eines Objekts (EF), wobei das Objekt (EF) im nichtflüchtigen Speicher (EEPROM) gespeichert ist, und andererseits eine vordefinierte Adresse (ADDR) im Inneren dieses Objekts (EF) zu speichern, wobei die Schaltung (PROC, ROM) bei der Verarbeitung eines Schreibbefehls eingerichtet ist, um den dem Schreibbefehl zugeordneten Objekt-Identifikationsparameter mit dem Identifikationsparameter (FID) eines im nichtflüchtigen Speicher (EEPROM) gespeicherten Objekts (EF) zu vergleichen, und im Fall eines positiven Vergleichs, um die im Schreibbefehl enthaltenen zu schreibenden Daten aus dem Pufferspeicher (BUF) in das dem Schreibbefehl zugeordnete Objekt an der im nichtflüchtigen Speicher (EEPROM) gespeicherten vordefinierten Adresse (ADDR) zu schreiben, um eine Adresse entsprechend der Summe der gespeicherten vordefinierten Adresse (ADDR) und der Größe der geschriebenen Daten zu berechnen, sowie um die berechnete Adresse im nichtflüchtigen Speicher (EEPROM) anstelle der vordefinierten Adresse (ADDR) zu speichern, wobei die Schaltung (PROC, ROM) im Fall eines negativen Vergleichs eingerichtet ist, um die im Schreibbefehl enthaltenen zu schreibenden Daten aus dem Pufferspeicher (BUF) in das dem Schreibbefehl zugeordnete Objekt an einer Standard-Adresse zu schreiben, um eine der Summe der Standard-Adresse und der Größe der geschriebenen Daten entsprechende Adresse zu berechnen, und um die berechnete Adresse im nichtflüchtigen Speicher (EEPROM) als vordefinierte Adresse zu speichern.

10. System, das eine elektronische Vorrichtung (PC, RDR) und eine Chipkarte (SC) nach Anspruch 9 enthält, wobei die elektronische Vorrichtung (PC, RDR) eingerichtet ist, um die von der Vorrichtung (PC, RDR) in die Chipkarte (SC) zu schreibenden Daten in derartige Untermengen aufzuteilen, dass die Größe jeder Untermenge höchstens gleich einem vorbestimmten Wert ist, um eine Gruppe von einem gleichen Objekt der Karte (SC) zugeordneten Schreibbefehlen aufzubauen, wobei jeder Schreibbefehl eine Untermenge von zu schreibenden Daten enthält, und um jeden so aufgebauten Schreibbefehl an die Karte (SC) zu senden.

## Claims

1. A method for writing data in a non-volatile memory of a smart card, comprising:
/a/ receiving a write command in a buffer in a volatile memory of the smart card,
/b/ comparing, by the smart card, an object identification parameter associated with the write command, with an object identification parameter stored in the non-volatile memory of the smart card,
/c/ if the comparison is positive,
/c1/ writing the data to be written, embedded in the write command, from the buffer to the object associated with the write command, at a predefined address whose value is stored in the non-volatile memory,
/c2/ calculating an address corresponding to the sum of the stored predefined address and the size of the written data,
/c3/ storing the calculated address in the non-volatile memory in place of the predefined address,
/d/ if the comparison is negative,
/d1/ writing the data to be written, embedded in the write command, from the buffer to the object associated with the write command, at a default address,
/d2/ calculating an address corresponding to the sum of the default address and the size of the written data,
/d3/ storing the calculated address in the non-volatile memory as the predefined address.

2. The method according to claim 1, wherein the object identification parameter associated with the write command is embedded in the write command.

3. The method according to claim 1, wherein the object identification parameter associated with the write command is stored in the volatile memory, and is updated by an object selection command of the smart card.

4. The method according to one of the preceding claims, wherein the default address is the zero address.

5. The method according to one of the preceding claims, wherein the command is encoded as an APDU command according to the ISO 7816-4 standard.

6. A method for writing data in a non-volatile memory of a smart card, by an electronic device, the method comprising:
/a/ separating, by the device, the data to be written into subsets, such that the size of each subset is at most equal to a predefined value,
/b/ constructing a set of write commands associated with a same object of the card, each write command containing a respective subset of data to be written,
/c/ sending each write command to the smart card by the device,
/d/ processing by the smart card each command received, according to the method according to one of claims 1 to 5.

7. A computer program comprising a series of instructions which, when executed by a processor of a smart card, implement the method according to one of claims 1 to 5.

8. A non-transitory computer-readable storage medium storing a computer program according to claim 7.

9. A smart card (SC) comprising a non-volatile memory (EEPROM), a volatile memory (RAM), a buffer (BUF) within the volatile memory, and a circuit (PROC, ROM) for processing write commands in non-volatile memory, said circuit (PROC, ROM) being arranged to process a command stored in the buffer (BUF) and associated with an identification parameter identifying an object stored in the non-volatile memory (EEPROM) where the command is to write to, said circuit (PROC, ROM) being arranged to store, in the non-volatile memory (EEPROM), on the one hand an identification parameter (FID) of an object (EF), the object (EF) being stored in the non-volatile memory (EEPROM), and on the other hand a predefined address (ADDR) within the object (EF), the circuit (PROC, ROM) being arranged, when processing a write command, to compare the object identification parameter associated with the write command with the object (EF) identification parameter (FID) stored in the non-volatile memory (EEPROM), and, if the comparison is positive, to write the data to be written, embedded in the write command, from the buffer (BUF) to the object associated with the write command, at the predefined address (ADDR) stored in the non-volatile memory (EEPROM), calculate an address corresponding to the sum of the stored predefined address (ADDR) and the size of the written data, as well as store the calculated address in the non-volatile memory (EEPROM) in place of the predefined address (ADDR), the circuit (PROC, ROM) being arranged, if the comparison is negative, to write the data to be written, embedded in the write command, from the buffer (BUF) to the object associated with the write command, at a default address, calculate an address corresponding to the sum of the default address and the size of the written data, and store the calculated address in the non-volatile memory (EEPROM) as the predefined address.

10. A system comprising an electronic device (PC, RDR) and a smart card (SC) according to claim 9, the electronic device (PC, RDR) being arranged to separate the data, to be written by the device (PC, RDR) to the smart card (SC), into subsets such that the size of each subset is at most equal to a predefined value, construct a set of write commands associated with a same object of the card (SC), each write command comprising a respective subset of data to be written, and send each write command constructed in this manner to the card (SC).
